# EUROPÄISCHE PATENTANMELDUNG

(11) **EP 0 538 770 A1**
(43) Veröffentlichungstag der Anmeldung: **28.04.1993**
(21) Anmeldenummer: 92117865.3
(22) Anmeldetag: 19.10.1992
(51) Int. Cl.: G01R 11/04

(54) **Doppeltarifzähler mit Tarifschaltgerät**

(30) Priorität: 23.10.1991 CH 3102/91
(71) Anmelder: ZELLWEGER LUWA AG, CH-8610 Uster (CH)
(72) Erfinder: Barca, Erik, CH-8607 Aathal-Seegräben (CH)
(74) Vertreter: Dittrich, Horst

(57) **Zusammenfassung**

Der Zähler enthält ein Gehäuse (2), einen Klemmenblock (3), einen Klemmendeckel (4) und ein als Modul ausgebildetes Tarifschaltgerät (5). Das letztere ist in den Klemmendeckel (4) eingebaut und weist eine Schnittstelle (10) zum Klemmenblock (3) auf.

## Beschreibung

Die vorliegende Erfindung betrifft einen Doppeltarifzähler zur Messung des elektrischen Energieverbrauchs, mit einem einen Messkreis enthaltenden Gehäuse, mit einem die erforderlichen Anschlüsse aufweisenden Klemmenblock, mit einem Klemmendeckel, und mit einem Tarifschaltgerät zum Umschalten des Zählers auf den jeweils gültigen Tarif.

Gerätekombinationen dieser Art sind bisher in drei Ausführungen bekannt. Entweder werden Zähler und Tarifschaltgerät in jeweils eigenen Gehäusen getrennt nebeneinander auf der Zählertafel montiert, oder das Tarifschaltgerät wird rucksackartig auf dem Klemmendeckel des Klemmenblocks montiert, oder das Tarifschaltgerät ist in den eigentlichen Zählerteil eingebaut. Die erste Ausführungsform hat den Nachteil eines relativ grossen Platzbedarfs und der zwischen den beiden Geräten verlaufenden, auf der Zählertafel zu führenden elektrischen Verbindungen; die zweite Ausführungsform ist zwar schon wesentlich kompakter, sie erfordert aber immer noch einen speziellen Klemmendeckel, durch den die elektrischen Anschlüsse nach aussen zum Tarifschaltgerät zu führen sind. Ausserdem wirkt diese Anordnung sehr klobig und entspricht jedenfalls nicht dem heutigen Verständnis von Gerätegestaltung. Die dritte Ausführungsform erfordert ein aufwendiges Zählergehäuse und einen für den Einbau des Tarifschaltgeräts vorbereiteten Zählerteil.

Durch die Erfindung soll nun ein Doppeltarifzähler mit einem Tarifschaltgerät angegeben werden, der sich durch geringen Platzbedarf, günstige Herstellungskosten und durch kompakte Bauweise auch in der Gerätetiefe auszeichnet und der einen einfachen Retrofit erlaubt.

Diese Aufgabe wird erfindungsgemäss dadurch gelöst, dass das Tarifschaltgerät modulartig ausgebildet und in den Klemmendeckel eingebaut ist und eine Schnittstelle zum Klemmenblock aufweist.

Bei der erfindungsgemässen Lösung entfällt also das eigene Gehäuse für das Tarifschaltgerät und dieses muss auch nicht aussen auf dem Klemmendeckel befestigt werden. Ebenso entfallen die vom Klemmenblock nach aussen zum Tarifschaltgerät führenden elektrischen Verbindungen. Es ist auch nicht mehr erforderlich, für Einfach- und Doppeltarifzähler verschiedene Klemmendeckel vorzusehen, sondern es genügt für beide Anwendungsfälle ein- und derselbe Klemmendeckel, der dann bei Bedarf mit dem Tarifschaltgerät ausgerüstet wird.

Im folgenden wird die Erfindung anhand eines Ausführungsbeispiels und der Zeichnungen näher erläutert; es zeigt:
- Fig. 1: eine perspektivische Ansicht eines mit einem Tarifschaltgerät ausgerüsteten Doppeltarifzählers; und
- Fig. 2: einen Längsschnitt durch den Zähler von Fig. 1 im Bereich des Tarifschaltgeräts.

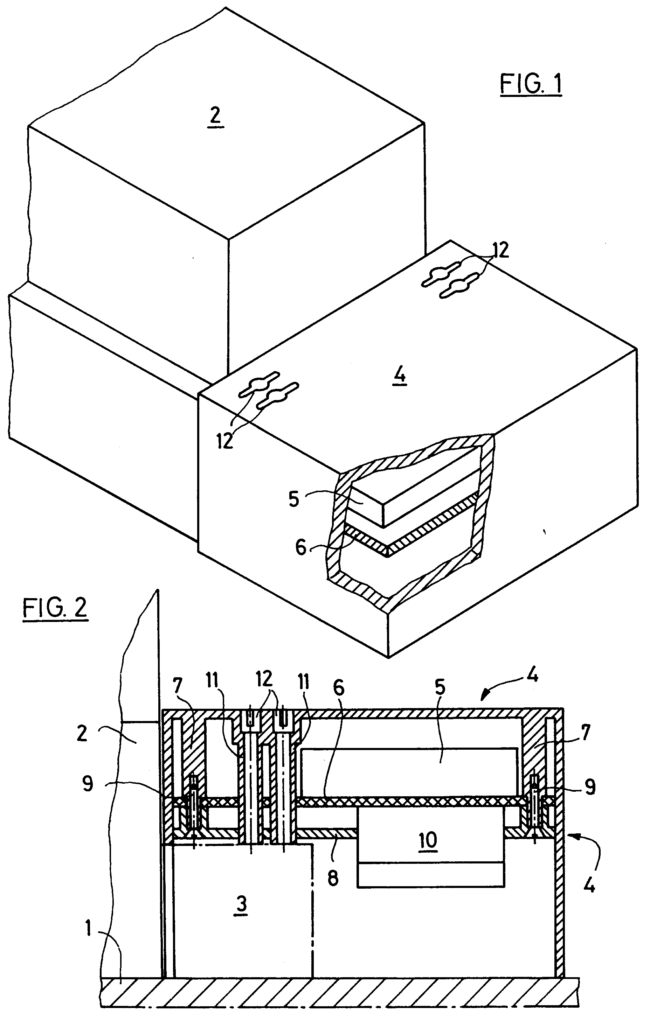

Darstellungsgemäss ist auf einer Zählertafel 1 ein Doppeltarifzähler montiert, von welchem in Fig. 1 der untere Teil des Gehäuses 2 dargestellt ist. Das Gehäuse enthält in bekannter Art mindestens einen Messkreis (nicht dargestellt) für den Verbrauchsstrom, dessen Anschlüsse zu einem Klemmenblock 3 geführt sind, welcher die erforderlichen externen Anschlüsse für die verschiedenen Strompfade sowie die Umschaltkontakte für das Doppeltarifzählwerk aufweist. Der Klemmenblock 3 ist durch einen Klemmendeckel 4 abgedeckt, der in seinem Innenraum ein Tarifmodul 5 zum Umschalten des Zählers auf verschiedene Tarifstufen aufweist. Dieses Tarifmodul ist im einfachsten Fall ein Timer, es kann aber auch ein fernsteuerbares elektronisches Schaltgerät, insbesondere ein Rundsteuerempfänger sein.

Das Tarifmodul 5 ist auf einer Tragplatte 6 befestigt, welche von geeigneten Befestigungsbolzen oder -rippen 7 des Klemmendeckels 4 durchsetzt und dadurch im Klemmendeckel zentriert ist. An der dem Tarifmodul 5 gegenüberliegenden Seite der Tragplatte 6 ist der Klemmendeckel 4 durch eine Abdeckplatte 8 abgeschlossen, welche über rohrstummelförmige Vorsprünge auf die aus der Tragplatte 6 ragenden Enden der Befestigungsbolzen 7 gesteckt und mit diesen durch Schrauben 9 verschraubt ist. Dadurch ist die Tragplatte 6 fest im Klemmendeckel 4 montiert.

An der Unterseite der Tragplatte 6 ist eine Schnittstelle 10 zwischen Tarifmodul 5 und Zähler befestigt, welche im einfachsten Fall durch eine Klemmenleiste gebildet ist, von welcher elektrische Verbindungen zum Klemmenblock 3 geführt sind. Die Schnittstelle 10 ragt durch eine entsprechende Oeffnung der Abdeckplatte 8 und wird von dieser passgenau umschlossen. Neben den schon genannten Befestigungsbolzen oder -rippen 7 weist der Klemmendeckel noch mehrere, darstellungsgemäss vier, nach innen ragende bolzenartige Vorsprünge 11 auf, welche ebenfalls die Abdeckplatte 8 und die Tragplatte 6 durchstossen und als Durchführung für Plombenschrauben 12 dienen.

Die ganze Anordnung ist sehr kompakt und einfach herzustellen und zu montieren, und sie ist darüber hinaus auch ausserordentlich stabil und widerstandsfähig gegenüber äusseren Einflüssen. Das Tarifmodul selbst befindet sich an einer geschützten Stelle im Innenraum des Klemmendeckels und ist auch bei abgenommenem Deckel immer noch gegen Beschädigungen geschützt.

## Patentansprüche

1. Doppeltarifzähler zur Messung des elektrischen Energieverbrauchs, mit einem einen Messkreis enthaltenden Gehäuse, mit einem die erforderlichen Anschlüsse aufweisenden Klemmenblock, mit einem Klemmendeckel, und mit einem Tarifschaltgerät zum Umschalten des Zählers auf den jeweils gültigen Tarif, dadurch gekennzeichnet, dass das Tarifschaltgerät (5) modulartig ausgebildet und in den Klemmendeckel (4) eingebaut ist und eine Schnittstelle (10) zum Klemmenblock (3) aufweist.

2. Zähler nach Anspruch 1, dadurch gekennzeichnet, dass das Tarifschaltgerät (5) von einer im Klemmendeckel (4) lösbar befestigten Tragplatte (6) getragen ist.

3. Zähler nach Anspruch 2, gekennzeichnet durch im Innenraum des Klemmendeckels (4) vorgesehene Befestigungsbolzen (7) für die Tragplatte (6), welche einerseits zur Zentrierung und andererseits zur Befestigung der Tragplatte im Klemmendeckel dienen.

4. Zähler nach Anspruch 3, dadurch gekennzeichnet, dass die Tragplatte (6) von den Befestigungsbolzen (7) durchstossen und mit diesen verschraubt ist.

5. Zähler nach einem der Ansprüche 1 bis 4, dadurch gekennzeichnet, dass der das Tarifschaltgerät (5) enthaltende Teil des Innenraums des Klemmendeckels (4) durch eine Abdeckplatte (8) abgeschlossen ist.

6. Zähler nach den Ansprüchen 4 und 5, dadurch gekennzeichnet, dass die Abdeckplatte (8) an den Befestigungsbolzen (7) befestigt ist.

7. Zähler nach Anspruch 6, dadurch gekennzeichnet, dass die Schnittstelle (10) an der vom Tarifschaltgerät (5) abgewandten Seite der Tragplatte (6) befestigt ist und durch die Abdeckplatte (8) ragt, von welcher sie passgenau umschlossen ist.
